# EUROPÄISCHE PATENTSCHRIFT

(11) **EP 0 899 879 B1**
(45) Veröffentlichungstag und Bekanntmachung des Hinweises auf die Patenterteilung: **29.10.2003**
(21) Anmeldenummer: 98202757.5
(22) Anmeldetag: 18.08.1998
(51) Int. Cl.: H03K 3/03

(54) **Ringoszillator**
Ring oscillator
Oscillateur en anneau

(30) Priorität: 23.08.1997 DE 19736857
(43) Veröffentlichungstag der Anmeldung: 03.03.1999
(73) Patentinhaber: Philips Intellectual Property & Standards GmbH, 20099 Hamburg (DE); Koninklijke Philips Electronics N.V., 5621 BA Eindhoven (NL)
(72) Erfinder: Pietrzyk, Michael, Philips Patentverwaltung GmbH, 22335 Hamburg (DE)
(74) Vertreter: Peters, Carl Heinrich, Dipl.-Ing.

(56) Entgegenhaltungen:
- EP-A- 0 306 662
- EP-A- 0 613 246
- US-A- 5 459 766
- US-A- 5 635 877

## Beschreibung

Die Erfindung bezieht sich auf einen Ringoszillator.

Derartige Schaltungen werden insbesondere zur Erzeugung von Systemtakten eingesetzt. Es sind Oszillatoren bekannt, in denen eine ungerade Anzahl von Invertern zu einem Ring zusammengeschaltet sind. Diese Art der Oszillatoren ist nicht frequenzvariabel.

In der EP 0 633 662 A1 wird eine Schaltungsanordnung für einen Ringoszillator beschrieben, die eine erste und eine zweite Reihenschaltung von n Treiberstufen aufweist,

die zu einem Ring zusammengeschaltet sind. Zwischen die Treiberstufen sind Haltestufen geschaltet. Mit dieser Schaltungsanordnung wird eine Frequenz erzeugt und von den einzelnen Anschlüssen werden ineinander verschachtelte, insbesondere komplementäre Signale abgegriffen.

Der Erfindung liegt die Aufgabe zugrunde, die vom Oszillator erzeugten Frequenzen schrittweise zu verändern, ohne daß dabei die Stromaufnahme verändert wird.

Diese Aufgabe wird gelöst durch einen schrittweise frequenzvariablen Ringoszillator, der umfaßt:
- eine gerade Anzahl von Paaren zu einem Ring zusammengeschalteter Ringinverter, wobei am Eingang jedes einzelnen Ringinverters ein phasenverschobenes Signal an einem Signalpunkt anliegt, sich die Phasenverschiebung zum Signal am vorherigen Signalpunkt aus dem Quotienten aus 360° durch die Anzahl der Ringinverter ergibt und die Ringinverter, deren Eingangssignale um 180° phasenverschoben zueinander sind, ein Ringinverterpaar bilden,
- die selbe gerade Anzahl von Querinverterpaaren,
   wobei jedes Querinverterpaar einem Ringinverterpaar zugeordnet ist und durch das zugeordnete Querinverterpaar die Ausgangssignale der Ringinverter auf den jeweiligen anderen Ausgang des zum Paar gehörenden Ringinverters zurückgekoppelt werden,
- die selbe gerade Anzahl von Paaren von Slope-Invertern,
   wobei jedes Slope-Inverterpaar einem Paar von Ringinvertern und den deren Eingänge festbildenden Signalpunkten zugeordnet ist, die Eingänge der Slope-Inverter in zwei Betriebsarten wechselseitig mit je einem der genannten Signalpunkte verbunden werden und die Ausgänge der Slope-Inverter fest mit Signalpunkten verbunden sind, die bezüglich der Signalpunkte am Eingang der jeweiligen Slope-Inverter eine Phasenverschiebung mit einem Betrag von 90° aufweisen, wobei in einer der Betriebsarten, die als " In Phase" bezeichnet ist, zwischen dem Eingang und dem Ausgang jedes Slope-Inverters eine Phasenverschiebung von 90° in positiver Richtung (voreilend) auftritt und in einer zweiten der Betriebsarten, die als "gegenphasig" bezeichnet ist, zwischen dem Eingang und dem Ausgang jedes Slope-Inverters eine Phasenverschiebung von 90° in negativer Richtung (nacheilend) auftritt.

Ringoszillatoren mit einer geraden Anzahl von Ringinvertern schwingen nicht, deshalb wird mit den Querinvertern der Ringoszillator zum Schwingen gebracht. Die Ringinverter sind in einer Reihe verschaltet und der Ausgang des letzten Ringinverters in der Reihe ist auf den Eingang des ersten Ringinverters zurückgekoppelt. Über die Querinverter wird das an jedem Signalpunkt anliegende Signal auf einen Signalpunkt mit einer Phasenverschiebung von 180° rückgekoppelt und dadurch die Schwingung angeregt. Die Slope-Inverter werden, wie die anderen genannten Inverter mit MOSFETs realisiert.

Da digitale Schaltungen unterschiedliche Systemtakte benötigen und dies durch Verändern der Oszillatorfrequenz realisierbar ist, ist durch Umschalten der Slope-Inverter eine schrittweise Veränderung der Oszillatorfrequenz erreichbar. Beim bloßen Dazuschalten ergäbe sich das Problem, daß jeder dazugeschaltete Inverter die Stromaufnahme erhöht und damit Spannungseinbrüche entstehen, die sich auf die Frequenz niederschlagen. Durch das Umschalten der Slope-Inverter ist immer die gleiche Anzahl von Invertern in der Schaltung aktiv und die Stromaufnahme bleibt konstant.

Ein weiterer Vorteil dieser Schaltung ist die Integrierbarkeit. Dadurch können externe Oszillatoren in bestehende Schaltungen platz- und materialsparend integriert werden.

Wenn alle Slope-Inverter in die gegenphasige Betriebsart geschaltet sind, wird die kleinste Frequenz erreicht, da die zu summierenden Signale gegenläufig sind und die Steilheit oder der Anstieg und dadurch auch die Frequenz geringer wird. Je mehr Paare von Slope-Invertern in die In-Phase-Betriebsart zu den Ringinvertern umgeschaltet werden, desto höher wird die Frequenz.

Durch das Kanalweitenverhältnis der MOSFETSs der Ringinverter zu den Slope-Invertern ist das Verhältnis der Veränderung der Frequenz einstellbar. Die Inverter haben durch die unterschiedlichen Kanalweiten der Transistoren andere Steilheiten, wodurch je nach Betriebsart die Steilheit des resultierenden Signals steigt oder geringer wird. Hierbei haben dann die zu einem Paar gehörenden Ringinverter ein festgelegtes Kanalweitenverhältnis zu den diesem Ringinverterpaar zugeordneten zwei Slope-Invertern. Wenn das Kanalweitenverhältnis bei allen Ringinverterpaaren zu den zugeordneten Slope-Invertern gleich ist, ergibt sich die Zahl der einstellbaren Frequenzen als Summe aus der Hälfte der Phasen des Ringoszillators zuzüglich eins, wobei die eins für die Frequenz steht, in der alle Slope-Inverterpaare gegenphasig geschaltet sind. Die einzelnen Ringinverterpaare können auch mit unterschiedlichen Kanalweitenverhältnissen zu den jeweils dazugehörenden Slope-Inverterpaaren betrieben werden. Wenn jedes Paar aus zwei Ringinvertern mit den dazugehörenden zwei Slope-Invertern ein anderes Kanalweitenverhältnis aufweist, ergibt sich die Zahl der einstellbaren Frequenzen als n-te Potenz von zwei, wobei n die Anzahl der Ringinverterpaare ist.

Da Systemtakte eine hohe Genauigkeit und Störsicherheit erfordern, wird der erfindungsgemäße Ringoszillator mit einer Stromeinspeisung gespeist, die eine Unterdrückung von Versorgungsspannungsmodulation ermöglicht und somit die Frequenz konstant hält.

Solche Oszillatoren lassen sich mit 4, 8, 12, 16 usw. Ringinvertern aufbauen, wodurch die Anzahl der Phasen bestimmt wird. Gleichzeitig wird damit die Anzahl der phasenverschobenen Signale oder die Anzahl der Signalpunkte festgelegt. In allen Realisierungen ist die Stromaufnahme immer gleich, da die Anzahl der Inverter, die im Ringoszillator aktiv eingebunden sind, immer gleich ist. Mit steigender Anzahl der Phasen nimmt die Zahl der einstellbaren Frequenzen zu.

Neben der Methode die Slope-Inverter statisch zu schalten, gibt es die Möglichkeit, diese alternierend umzuschalten.

Durch Veränderung des Tastverhältnisses oder der Schaltfrequenz für die Umschalter sind weitere Zwischenfrequenzen zu erreichen.

Ausführungsbeispiele der Erfindung werden nachstehend anhand der Zeichnungen näher erläutert. Es zeigen:
- Fig. 1: eine Schaltungsanordnung eines Vier-Phasen-Ringoszillators,
- Fig. 2: eine Außenbeschaltung und die Stromeinspeisung eines Vier-Phasen-Ringoszillators,
- Fig. 3: den allgemeinen Aufbau eines verwendeten Inverters,
- Fig. 4: eine Schaltungsanordnung eines Sechzehnphasen-Ringoszillators.

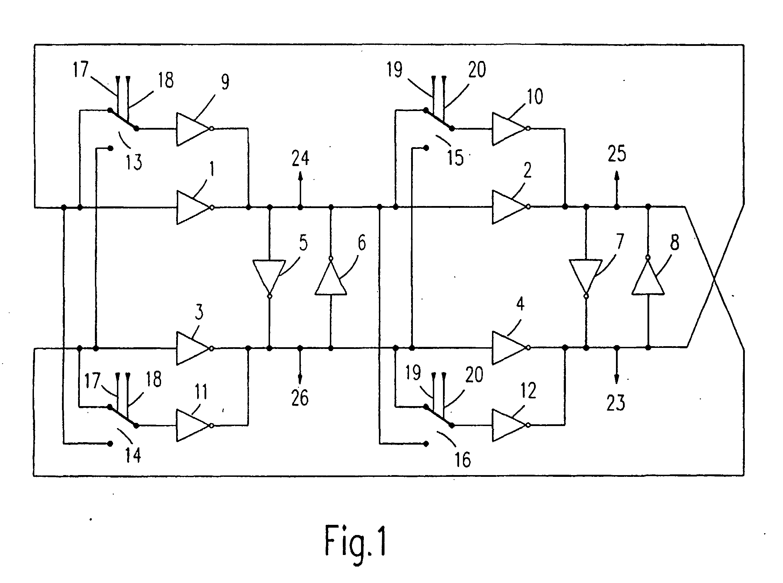

Die in Fig. 1 dargestellte Schaltungsanordnung zeigt einen Aufbau eines Vier-Phasen-Ringoszillators. Ein Vier-Phasen-Ringoszillator hat vier unterschiedliche Ausgangssignale, die alle um 90° phasenverschoben zueinander sind und an den Signalpunkten 23, 24, 25, 26 abgegriffen werden. Es lassen sich mindestens drei, maximal vier unterschiedliche Frequenzen einstellen.

Der Vier-Phasen-Ringoszillator nach Fig. 1 enthält die vier Ringinverter 1, 2, 3, 4, die zu einem Ring geschaltet sind. Zwischen diese Ringinverter 1, 2, 3, 4 sind Querinverter 5, 6, 7, 8 so geschaltet, daß sie diesen Ring aus der geraden Anzahl von Ringinvertern zum Schwingen anregen. Ferner sind vier Slope-Inverter 9, 10, 11, 12 über Schalter 13, 14, 15, 16 mit Schaltsignalen 17, 18, 19 bzw. 20 je nach Betriebsart auf entsprechende Signalpunkte 23, 24, 25, 26 umschaltbar. In dieser Anordnung bilden die Ringinverter 1 und 3 ein Paar, dem die Querinverter 5 und 6 und die Slope-Inverter 9 und 11 zugeordnet sind. Die Eingänge des Ringinverterpaares 1 und 3 sind mit den Signalpunkten 23 u. 25 verbunden. Die Ausgänge der Slope-Inverter 9 und 11 sind in diesem einfachsten Fall auch an die Ausgänge der Ringinverter 1 und 3 und an die Signalpunkte 24, 26 angeschlossen. Ringinverter 2 und 4, die dazugehörigen Querinverter 7 und 8 und die Slope-Inverter 10 und 12, mit den Signalpunkten 24, 26 für die Eingänge der Ring- 2 u.4 und Slope-Inverter 10 u.12 und den Signalpunkten 23 und 25, mit denen die Ausgänge der genannten Slope- und Ringinverter verbunden sind, bilden das andere Paar. Das Signal am Signalpunkt 24 wird über den Querinverter 5 auf Signalpunkt 26 zurückgekoppelt, da hier das Signal in bezug auf Signalpunkt 24 um 180° phasenverschoben anliegt, und das Signal am Signalpunkt 26 wird über den Querinverter 6 auf den Signalpunkt 24 zurückgekoppelt. In gleicher Weise sind die Signalpunkte 25 und 23 miteinander verschaltet. Die Slope-Inverterpaare werden je nach Schaltsignal zu dem jeweiligen Ringinverterpaar in die Betriebsarten "In-Phase" oder "gegenphasig" geschaltet.

An den Ringinvertern 1 u. 3 sollen die zwei Betriebsarten und deren Funktion beispielhaft erklärt werden.

Für Ringinverter 1 ist das Signal vom Signalpunkt 23 Eingangssignal und für Ringinverter 3 das Signal vom Signalpunkt 25. Diese Signalpunkte haben eine Phasenverschiebung von 180° zueinander. Soll die Frequenz des Ringoszillators erhöht werden, werden den Ringinvertern 1 und 3 gleichzeitig die dazugehörigen Slope-Inverter 9 und 11 aus der Betriebsart "gegenphasig" in die Betriebsart "In- Phase" umgeschaltet. Da die beiden zu addierenden Signale am Signalpunkt 24 mitgekoppelt werden, steigt die Frequenz. Dem Ringinverter 1 wird der Slope-Inverter 9 in Phase geschaltet, da am Signalpunkt 24, an dem der Ausgang vom Slope-Inverter 9 liegt, ein Signal mit einer positiven Phasenverschiebung von 90° bezüglich Signalpunkt 23 anliegt. Dem Ringinverter 3 wird der Slope-Inverter 11 in Phase geschaltet, da am Signalpunkt 26 ein Signal mit einer positiven Phasenverschiebung von 90° bezüglich Signalpunkt 25 anliegt.

Bei gegenphasiger Schaltung, zur Verringerung der Frequenz, wird der Slope-Inverter 9 dem Ringinverter 3 zugeordnet. Dazu wird der Slope-Inverter 9 mit dem Signalpunkt 25 vor dem Ringinverter 3 verbunden. Da zwischen Signalpunkt 23 und 25 eine Phasenverschiebung von 180° auftritt, liegt bezüglich des Signalpunktes 24 am Ausgang von Slope-Inverter 9 eine Phasenverschiebung von 270° aus der Sicht von Signalpunkt 25 vor, die auch gleichzeitig eine Phasenverschiebung von 90° in negative Richtung darstellt. Für den anderen zu diesem Paar gehörenden Ringinverter 1 wird diesem bei gegenphasiger Schaltung der Slope-Inverter 11 zugeordnet. Dazu wird der Slope-Inverter 11 mit dem Signalpunkt 23 vor dem Ringinverter 1 verbunden, weil zwischen Signalpunkt 23 am Eingang der betrachteten Inverter 1 und 11 und dem Signalpunkt 26 am Ausgang des Slope-Inverters 11 eine negative Phasenverschiebung von 90° auftritt. Durch die gegenläufigen Signale an den Signalpunkten bei gegenphasiger Schaltung sinkt die Frequenz.

Die Slope-Inverter werden immer paarweise zwischen den Betriebsarten umgeschaltet. Das Umschalten der Slope-Inverter von "In-Phase" auf "gegenphasig" und umgekehrt erfolgt über die Umschalter 13, 14, 15, 16, wobei die Schalter 13 und 14 gleichzeitig über das Schaltsignal 17 oder 18 betrieben werden und die Schalter 15 und 16 gleichzeitig über das Schaltsignal 19 oder 20. Die Schaltsignale 17 und 18 sind invers zueinander, ebenso 19 und 20.

Bei Anliegen des Schaltsignals 17 an den Schaltern 13 und 14 wird dem Ringinverter 1 der Slope-Inverter 9 und gleichzeitig dem Ringinverter 3 der Slope-Inverter 11 in Phase geschaltet. Unabhängig davon kann gleichzeitig oder nicht gleichzeitig das Signal 19 am Schalter 15 und 16 anliegen, wodurch die Slope-Inverter 10 und 12 den jeweiligen Ringinvertern 2 und 4 in Phase geschaltet werden. Bei Anliegen des Signals 18 an den Schaltern 13 und 14 wird dem Ringinverter 1 der Slope-Inverter 11 und dem Ringinverter 3 der Slope-Inverter 9 gegenphasig geschaltet. Dem Ringinverter 2 wird bei Anliegen des Signals 20 am Schalter 16 der Slope-Inverter 12 gegenphasig geschaltet, und da der Schalter 15 gleichzeitig dieses Signal 20 erhält, wird dem Ringinverter 4 der Slope-Inverter 10 gegenphasig geschaltet.

Aus Fig. 1 ist ersichtlich, daß in dieser Schaltungsanordnung immer die gleiche Anzahl von Invertern betrieben wird, so daß sich das Umschalten von phasenrichtigem auf gegenphasigen Betrieb nicht durch eine Veränderung der Stromaufnahme bemerkbar macht.

Das Verhältnis der Kanalweiten der Transistoren in den Slope-Invertern und den Ringinvertern bestimmt die erreichbare Frequenzänderung. Wenn alle Slope-Inverterpaare zu den dazugehörenden Ringinverterpaaren beispielsweise ein gleiches Kanalweitenverhältnis von 1:2 haben, wird je nach Betriebsart die Frequenz erhöht oder geschwächt, da die Slope-Inverter eine andere Steilheit als die Ringinverter aufweisen. In diesem Beispiel lassen sich drei verschieden Frequenzen einstellen. Wenn man die Frequenz der Kombination aus dem " In-Phase" geschaltetem Slope-Inverterpaar 9 u. 11 und dem anderen "gegenphasig" geschaltetem Slope-Inverterpaar 10 u. 12 als eine Mittelfrequenz betrachtet, halbiert sich diese Frequenz, wenn die Slope-Inverter 9 u. 11 zu den Ringinvertern 1 u. 3 auch in die Betriebsart "gegenphasig" geschaltet werden, weil die resultierende Steilheit oder der Anstieg des Signals durch die Gegenkopplung an den Signalpunkten 24 und 26 kleiner wird. In dieser oben genannten Kombination bewirkt ein Umschalten des zweiten Slope-Inverterpaares 10, 12 in die erste Betriebsart " In-Phase" eine Erhöhung der Mittelfrequenz um das 1,5 fache, so daß insgesamt bei einem Vier-Phasen Oszillator eine Verdreifachung einer Grundfrequenz, in der alle Slope-Inverter gegenphasig geschaltet sind, möglich ist. Wenn das Kanalweitenverhältnis der Slope-Inverter 9 u. 11 zu den Ringinvertern 1 u. 3 anders als das Kanalweitenverhältnis der Slope-Inverter 10 u. 12 zu den Ringinvertern 2 u. 4 ist, lassen sich vier unterschiedliche Frequenzen einstellen, da die Frequenz bei Betrieb der Slope-Inverter 9 u. 11 in der ersten Betriebsart eine andere als die bei Betrieb der Slope-Inverter 10 u. 12 in der ersten Betriebsart ist.

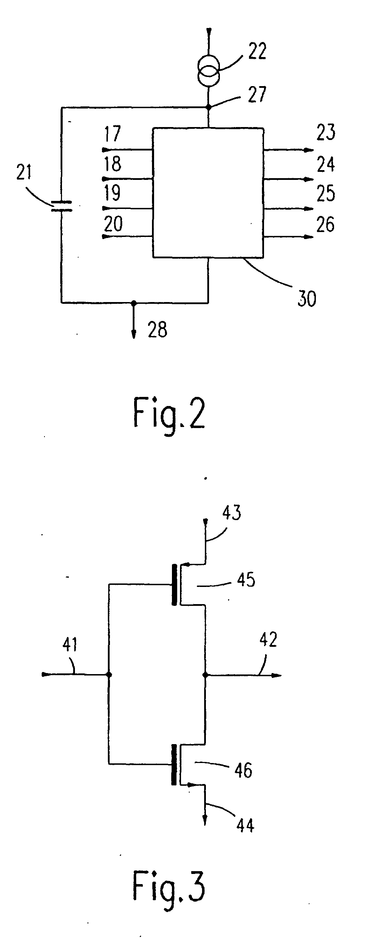

Fig. 2 zeigt eine Außenbeschaltung eines Ringoszillators 30. Über eine Stromquelle 22 wird der Ringoszillator 30 betrieben. Es wird mit der hochohmigen Stromquelle 22 eine Spannung am Punkt 27 erzeugt, die über einem Entstörkondensator 21 und dem Innenwiderstand des Oszillators 30 anliegt. Hierdurch folgt die Spannung an Punkt 27 einem Bezugspotential 28, so daß eine Störspannung, mit der das Bezugspotential 28 moduliert sein kann, keinen Einfluß auf die Frequenz des Ringoszillators hat. Die Signale 17 und 18, 19 und 20 werden aus einer nicht dargestellten digitalen Schaltung den Umschaltern (13,14,15,16 in Fig.1) im Ringoszillator 30 zugeführt. Die Signale 23, 24, 25, 26 stellen die Signalpunkte des Ringoszillators 30 dar, von denen die eingestellte Frequenz, um jeweils 90° phasenverschoben, abgegriffen wird.

Fig. 3 zeigt eine Inverterzelle, wie sie für die drei Arten genannter Inverter verwendet wird, bestehend aus einem p-Kanal MOSFET 45 und einem n-Kanal MOSFET 46, mit einem Bezugspotential 44 und einer Versorgungsspannung 43. Über einen Eingang 41 wird je nach Pegel einer der zwei Transistoren 45, 46 in einen leitenden Zustand versetzt, wodurch ein Ausgang 42 auf ein entgegengesetztes Potential gezogen wird und somit ein negiertes Signal ausgibt.

Die in den einzelnen Invertern verwendeten Transistoren, z.B. 45 und 46, weisen unterschiedliche Kanalweiten auf, um die Steilheit der n- und p-Kanaltransistoren möglichst gleich zu halten und somit einen symmetrischen Umschaltpunkt für den Inverter zu erzeugen.

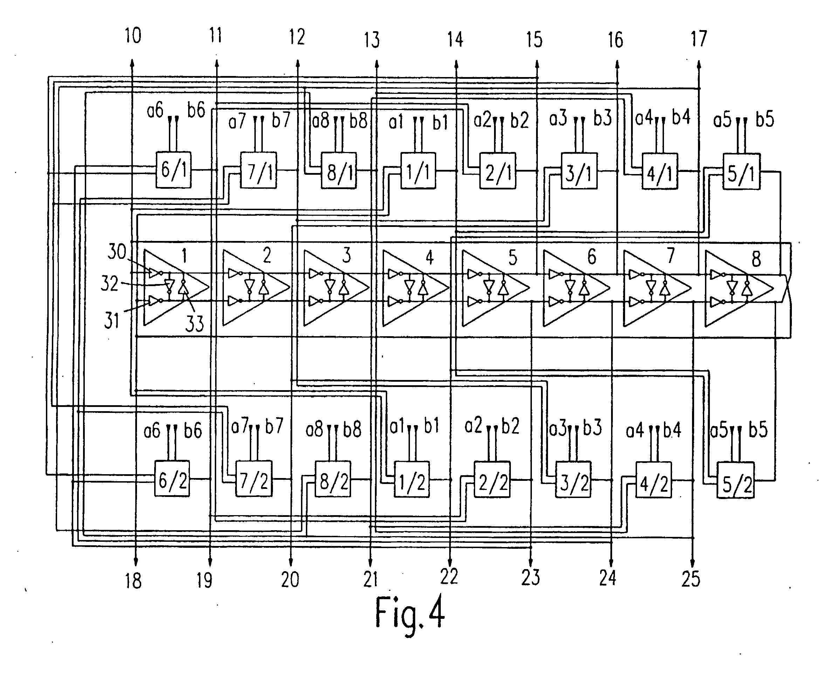

Fig. 4 zeigt eine Schaltungsanordnung für einen Sechzehnphasen-Ringoszillator, bei dem jeweils die paarweisen Ringinverter in Blöcken 1-8 mit dazugehörigen Querinverterpaaren zusammengefaßt sind.
Dieser Sechzehnphasen-Oszillator hat sechzehn Signalpunkte 10-25, an denen die phasenverschobenen Frequenzen mit einer Phasenverschiebung von 22,5° zwischen aufeinanderfolgenden Signalpunkten anliegen. Slope-Inverter n/1, n/2 mit n=(1..8) sind paarweise jeweils einem Block n zugeordnet und werden über Schaltsignale a1..a8 für die erste Betriebsart und b1...b8 für die zweite Betriebsart gesteuert, wobei die Schaltsignale a1..a8 und b1..b8 invers zueinander sind und dem Ringoszillator von außen zugeführt werden.

Um einen Slope-Inverter mit dem Schaltsignal a in Phase zu schalten, ist der Ausgang des Slope-Inverters mit dem vierten folgenden Signalpunkt verbunden, da das Signal dort um 90°positiv phasenverschoben ist. Für den gegenphasigen Betrieb, der mit dem Schaltsignal b einstellbar ist, ist der Slope-Inverter in entgegengesetzte Richtung mit einem Signalpunkt verbunden, der vier Signalpunkte vor dem Signalpunkt des Eingangs des Slope-Inverters liegt, um die 90° negative Phasenverschiebung zu erreichen.

Anhand der Fig.4 soll dies für eine Möglichkeit ausgeführt werden. Im Block 1 befinden sich zwei Ringinverter 30, 31 und zugeordnete Querinverter 32, 33. Signalpunkt 10 ist für Ringinverter 30 der Eingang. Dem Ringinverter 30 im Block 1 wird der Slope-Inverter 1/1 mit dem Schaltsignal a1 in Phase geschaltet, gleichzeitig wird dem Ringinverter 31 mit Signalpunkt 18 der Slope-Inverter 1/2 mit dem selben Schaltsignal a 1 in Phase geschaltet. Das Signal von Slope-Inverter 1/1 wird am Signalpunkt 14 eingekoppelt, da erst hier, vier Signalpunkte weiter, das Signal um 90° phasenverschoben anliegt, da jeder Block nur 22,5° Phasenverschiebung bewirkt. Ebenso wird das Signal von Slope-Inverter 1/2 erst am Signalpunkt 22 eingekoppelt. Für den gegenphasigen Betrieb, vom Signalpunkt 10 ausgehend über den Slope-Inverter 1/2, wird das Signal auf den Signalpunkt 22, der in bezug auf den Signalpunkt 10 ein um 90° negativ verschobenes Signal aufweist, gekoppelt. Der Eingang des Ringinverter 31, Signalpunkt 18, wird bei gegenphasigem Betrieb mit dem Slope-Inverter 1/1 verbunden, da dessen Ausgang, Signalpunkt 14, bezüglich Signalpunkt 18 eine negative Phasenverschiebung von 90°aufweist.

Dem gleichen Prinzip folgend, wie der Vier-Phasen-Ringoszillator der in Fig. 1 beschrieben wurde, ist in diesem Ringoszillator immer die gleiche Anzahl von Invertern aktiv, so daß sich auch hier keine Veränderung in der Stromaufnahme ergibt. Das paarweise "In-Phase"-Schalten der Slope-Inverter erhöht die Frequenz. Wenn alle acht Paare der Slope-Inverter phasenrichtig geschaltet sind, ist die höchste Frequenz erreichbar. Sind die Slope-Inverter alle gegenphasig geschaltet, ist die kleinste Frequenz erreichbar. Durch Umschalten einiger Slope-Inverterpaare erreicht man Zwischenfrequenzen. Mit dem 16 Phasen-Oszillator sind 9 verschiedene Frequenzen einstellbar, bei gleichen Kanalweitenverhältnissen der Ringinverter der Blöcke 1-8 zu den zugeordneten Slope-Invertern. Sind die Kanalweitenverhältnisse der Ringinverter in den Blöcken 1-8 zu den zugeordneten Slope-Invertern alle unterschiedlich, lassen sich 28 verschiedene Frequenzen einstellen.

Durch ein statisches Schalten der Slope-Inverterpaare in eine der Betriebsarten "In-Phase" oder gegenphasig" werden unterschiedliche Frequenzen erreicht. Taktet man ein Slope-Inverterpaar, indem man die Umschalter vor den ausgewählten Slope-Invertern eines Paares mit einer entsprechenden Frequenz alternierend zwischen den zwei Betriebsarten umschaltet, z.B. mit der halben Oszillatorfrequenz, erreicht man, daß die beiden Slope-Inverter für zwei Taktflanken "In-Phase" und für die nächsten zwei Taktflanken "gegenphasig" sind. Dies führt zu einer mittleren Oszillatorfrequnez, die zwischen den Frequenzen liegt, die erreicht werden, wenn das Slope-Inverterpaar statisch "In-Phase" oder "gegenphasig" geschaltet ist.

## Patentansprüche

1. Ringoszillator, umfassend
- eine gerade Anzahl von Paaren zu einem Ring zusammengeschalteter Ringinverter, wobei am Eingang jedes einzelnen Ringinverters ein phasenverschobenes Signal an einem Signalpunkt anliegt, sich die Phasenverschiebung zum Signal am vorherigen Signalpunkt aus dem Quotienten aus 360° durch die Anzahl der Ringinverter ergibt und die Ringinverter, deren Eingangssignale um 180° phasenverschoben zueinander sind, ein Ringinverterpaar bilden,
- die selbe gerade Anzahl von Querinverterpaaren,
wobei jedes Querinverterpaar einem Ringinverterpaar zugeordnet ist und durch das zugeordnete Querinverterpaar die Ausgangssignale der Ringinverter auf den jeweiligen anderen Ausgang des zum Paar gehörenden Ringinverters zurückgekoppelt werden,
- die selbe gerade Anzahl von Paaren von Slope-Invertern,
wobei jedes Slope-Inverterpaar einem Paar von Ringinvertern und den deren Eingänge festbildenden Signalpunkten zugeordnet ist,
die Eingänge der Slope-Inverter in zwei Betriebsarten wechselseitig mit je einem der genannten Signalpunkte verbunden werden und die Ausgänge der Slope-Inverter fest mit Signalpunkten verbunden sind, die bezüglich der Signalpunkte am Eingang der jeweiligen Slope-Inverter eine Phasenverschiebung mit einem Betrag von 90°aufweisen, wobei in einer der Betriebsarten, die als "In-Phase" bezeichnet ist, zwischen dem Eingang und dem Ausgang jedes Slope-Inverters eine Phasenverschiebung von 90° in positiver Richtung auftritt und in einer zweiten der Betriebsarten, die als "gegenphasig" bezeichnet ist, zwischen dem Eingang und dem Ausgang jedes Slope-Inverters eine Phasenverschiebung von 90° in negativer Richtung auftritt.

2. Ringoszillator nach Anspruch 1, **dadurch gekennzeichnet, daß** die Frequenzen von dem Verhältnis der Kanalweiten der Transistoren der Ringinverter und der Slope-Inverter abhängen.

3. Ringoszillator nach Anspruch 1, **dadurch gekennzeichnet, daß** ein Umschalter für die Slope-Inverter vor oder hinter den Slope-Invertern angeordnet sein kann.

4. Ringoszillator nach Anspruch 1, **dadurch gekennzeichnet, daß** der Ringoszillator durch eine Stromquelle gespeist wird.

5. Ringoszillator nach Anspruch 1, **dadurch gekennzeichnet, daß** Umschalter paarweise auswählbar für Paare von Slope-Invertern mit einer Frequenz zwischen den zwei Betriebsarten umschaltbar sind.

## Claims

1. A ring oscillator comprising
- an even number of ring inverter pairs
combined to a ring, in which the input of each individual ring inverter conveys a phase-shifted signal at a signal point, the phase shift with respect to the signal at the previous signal point results from the quotient of 360° by the number of ring inverters, and the ring inverters, whose input signals are phase-shifted by 180° with respect to each other, constitute a ring inverter pair,
- the same even number of shunt inverter pairs,
in which each shunt inverter pair is assigned to a ring inverter pair and the assigned shunt inverter pair feeds back the output signals of the ring inverters to the respective other output of the ring inverter associated with the pair,
- the same even number of slope inverter pairs,
in which each slope inverter pair is assigned to a pair of ring inverters and to the signal points constituting their inputs,
the inputs of the slope inverters are alternately connected in two modes to a respective one of said signal points, and the outputs of the slope inverters are fixedly connected to signal points which, with reference to the signal points at the input of each slope inverter, have a phase shift of 90°, in one of the modes, referred to as "in-phase", a phase shift of 90° in the positive direction occurs between the input and the output of each slope inverter, and in a second mode, referred to as "anti-phase", a phase shift of 90° occurs in the negative direction between the input and the output of each slope inverter.

2. A ring oscillator as claimed in claim 1, **characterized in that** the frequencies are dependent on the channel width ratios of the transistors of the ring inverters and the slope inverters.

3. A ring oscillator as claimed in claim 1, **characterized in that** a switch for the slope inverters may precede or follow said slope inverters.

4. A ring oscillator as claimed in claim 1, **characterized in that** the ring oscillator is fed by a current source.

5. A ring oscillator as claimed in claim 1, **characterized in that** switches pairwise selectable for slope inverter pairs are switchable at a frequency between the two modes.

## Revendications

1. Oscillateur en anneau comprenant :
- un nombre pair de paires d'inverseurs en anneau montés en un anneau, un signal déphasé étant appliqué à un point du signal à l'entrée de chaque inverseur en anneau individuel, le déphasage par rapport au signal au point de signal précédent étant obtenu à partir du quotient de 360° par le nombre d'inverseurs en anneau et les inverseurs en anneau dont les signaux d'entrée sont déphasés de 180° l'un par rapport à l'autre formant une paire d'inverseurs en anneau;
- le même nombre pair de paires d'inverseurs transversaux, chaque paire d'inverseurs transversaux étant affectée à une paire d'inverseurs en anneau et, par la paire d'inverseurs transversaux affectés, les signaux de sortie des inverseurs en anneau étant réinjectés sur l'autre sortie respective de l'inverseur en anneau appartenant à la paire,
- le même nombre pair de paires d'inverseurs en pente, chaque paire d'inverseurs en pente étant affectée à une paire d'inverseurs en anneau et aux points de signal formant leurs entrées, les entrées des inverseurs en pente étant reliées en alternance avec l'un desdits points de signal respectifs dans deux modes de fonctionnement et les sorties des inverseurs en pente étant reliées à demeure avec les points du signal qui présentent par rapport aux points de signal à l'entrée des inverseurs en pente respectifs un déphasage d'une valeur de 90°, un déphasage de 90° en direction positive (en avance de phase) se produisant dans un des modes de fonctionnement qui est désigné comme "en phase" entre l'entrée et la sortie de chaque inverseur en pente et un déphasage de 90° en direction négative (en retard de phase) se produisant entre l'entrée et la sortie de chaque inverseur en pente dans un deuxième des modes de fonctionnement désigné comme "en opposition de phase".

2. Oscillateur en anneau selon la revendication 1, **caractérisé en ce que** les fréquences dépendent du rapport des largeurs de canal des transistors des inverseurs en anneau et des inverseurs en pente.

3. Oscillateur en anneau selon la revendication 1, **caractérisé en ce qu'**un commutateur pour les inverseurs en pente peut être disposé avant ou après les inverseurs en pente.

4. Oscillateur en anneau selon la revendication 1, **caractérisé en ce que** l'oscillateur en anneau est alimenté par une source de courant.

5. Oscillateur en anneau selon la revendication 1, **caractérisé en ce que** les commutateurs peuvent être commutés par paire au choix pour des paires d'inverseurs en pente avec une fréquence entre les deux modes de fonctionnement.
